# EUROPEAN PATENT APPLICATION

(11) **EP 2 355 351 A1**
(43) Date of publication of application: **10.08.2011**
(21) Application number: 10305092.8
(22) Date of filing: 27.01.2010
(51) Int. Cl.: H03K 5/13, H03M 1/00

(54) **Improved RTZ pulse generator**

(71) Applicant: Primachip, 13382 Marseille Cedex 13 (FR)
(72) Inventor: Dufaza, Christian, 34230 Saint-Pargoire (FR); Ihs, Hassan, 34080 Montpellier (FR)
(74) Representative: Hautier, Nicolas

(57) **Abstract**

An improved pulse generator for driving return-to-zero (RTZ) circuitry sensitive to noise coupling and clock jitter is described. It is characterized it comprises means for generating a pulse from a system clock (250), a delay line (210) driven by the system clock (250), decoding means associated to the delay line for shifting away (280, 282) the active level of the pulse from transitions of the system clock(250), and in that it is arranged so that the delay line is locked on the system clock (250) and the active level (285) of the pulse is determined by the delay line.

## Description

### FIELD OF THE INVENTION

The present invention relates generally to noise reduction in electronic circuitry and more specifically describes a design technique to minimize the effects of noise coupling on the analog part of mixed-signal integrated circuits.

### BACKGROUND OF THE INVENTION

For decades, a constant increase of the level of integration of the building blocks used by the microelectronics industry, i.e.: integrated circuits (IC's), has been observed. Following Moore's law, a doubling of the integration of digital IC's has indeed been sustained, about every two years, since the 60's. Systems on a chip (SOC's) have thus become a reality in the past years.

As a consequence, while analog circuits and digital circuits have long been implemented on different parts, generally using different technologies and processes, they tend to be now integrated on a single semiconductor die using a common technology. Called mixed-signal integrated circuits these IC's house both analog circuits and digital circuits on a single chip.

Mixed-signal IC's typically include all sorts of analog to digital converters (ADC's) and their counterparts, i.e.: digital to analog converters (DAC's) so that it becomes possible to implement a whole function or sub-function on a single chip. Hence, analog signals can be digitized and any complex processing applied on them, in a digital form, like filtering, fast Fourier transforms (FFT) and, generally, all the operations that are usually performed with a digital signal processor (DSP). After which, the processed signals can be restored, e.g., to an audio equipment through integrated DAC's.

The design of a mixed-signal IC requires a high level of expertise. A particularly challenging task, applicable to any mixed-signal IC, is to minimize noise coupling between various parts of the whole system. Sensitive analog circuits and noisy digital circuits must be able to effectively coexist on a SOC. While digital circuits are relatively immune to noise, due to their higher noise margins (typically measured in tenths of volts), the addition of analog circuits may have a significant impact on the performance of the system because noise levels that can be tolerated in the analog part are rather in the millivolt and microvolt range.

The primary mixed-signal noise coupling problem thus comes from high-swing and fast-changing digital signals coupling to sensitive analog nodes. One of the paths through which mixed-signal noise coupling occurs is the substrate. Digital operations cause fluctuations in the underlying substrate voltage. They spread through the common substrate causing variations in the analog part. This is referred to as substrate coupling or substrate noise coupling. The reduced distance between analog and digital circuits, which is the result of the constant increase of the integration level mentioned above, and which obtained by down scaling the technologies used to implement IC's, may only exacerbate the substrate coupling.

Besides the implementation of standard design practices (e.g., independent power and ground connections for digital and analog circuits are always provided in mixed-signal IC's) a variety of techniques are already in use in order to improve substrate noise coupling. They include such things as implementing highly doped guard-rings and using differential topology, on-chip decoupling, and triple-well isolation. For example, an improvement on this latter technique has been disclosed in US patent 7,052,966 untitled 'Deep N wells in triple well structures and method for fabricating same'.

Although the above implementation techniques contribute significantly to reduce the main source of noise affecting the analog part of mixed-signal IC's they cannot cancel it completely. Mixed-signal IC designers are thus always eager to find new solutions and improvements to further minimize the effects of noise coupling between analog and digital parts. This is necessary to compensate for the undesirable effects of the constant down scaling of the technologies used to fabricate these IC's. Down scaling is often accompanied by a corresponding reduction of the power supply voltage values which does not facilitate the implementation of analog circuits. And, in general, there is always a benefit to increase the signal to noise ratio (SNR) of any analog circuitry, by lowering the noise, so that, e.g., an analog to digital conversion can be achieved with a better resolution or, for a same resolution, less power can be dissipated or better conversion performances can be obtained.

It is then an object of the invention to disclose a novel design technique that contributes to further minimize the effects of digital noise coupling on the analog part of mixed-signal IC's.

Further objects, features and advantages of the present invention will become apparent to the ones skilled in the art upon examination of the following description in reference to the accompanying drawings. It is intended that any additional advantages be incorporated herein.

### SUMMARY OF THE INVENTION

The above objects of the invention are fulfilled by the invention which describes an apparatus for generating a pulse for driving return-to-zero circuitry sensitive to noise coupling. The pulse generator is characterized in that it comprises means for generating a pulse from a system clock, a delay line driven by the system clock and decoding means associated to the delay line for shifting away the active level of the pulse from transitions of the system clock.

Preferably, the pulse generator is arranged so that the delay line is locked on the system clock and the active level of the pulse is determined by the delay line.

The pulse generator may further includes any one of the following optional means and features:
- the decoding means are arranged for decoding a duration and a shift of the active level from outputs of individual delay elements forming the controlled delay line and means for locking the controlled delay line on the period, or fraction of, of the regular system clock.
- means for locking the controlled delay line on half a period of the regular system clock;
- each individual delay element includes a transconductance device and an inverter;
- the pulse generator comprises means for adjusting a reference current of the transconductance devices from a feedback voltage generated from a phase frequency detector and a charge pump both part of the means for locking the controlled delay line;
- the delay line is comprised of four individual delay elements;
- the pulse generator comprises is arranged so that the active level of the pulse is shifted of one eight of the system clock period from the regular system clock transitions;
- the pulse generator comprises is arranged so that the active level of the pulse is shifted of one fourth of the system clock period from the regular system clock transitions;
- the means for decoding is an exclusive or gate.
- the pulse generator comprises is arranged so that the effect of noise coupling is minimized by time shifting the said noise coupling into a non-active time window of the return-to-zero circuitry.
- there is no two separate means for controlling the duration and the shift of the pulse. The two result from the decoding circuit. According to an embodiment of the invention the two result from the XOR gate and from where inputs are connected;
- the clock system is a regular clock system;
- the delay line is an analog delay line.

Another object of the invention is analog to digital converter, or a return-to-zero digital to analog converter, including a pulse generator according to any of the previous features. Advantageously, the converter may be of a continuous-time sigma-delta type.

The invention further describes an audio-phonics apparatus comprising any one of the above converters.

The invention moreover describes a method for generating a pulse aimed at driving return-to-zero circuitry sensitive to noise coupling. The method is characterized in that it comprises the steps of generating a pulse from a system clock and shifting away the active level of the pulse from transitions of the system clock through a delay line.

The method may further includes the steps of:
- decoding a duration and a shift of the active level from outputs of individual delay elements forming the controlled delay line;
- locking the controlled delay line on the period, or fraction of, of the regular system clock.
- determining an active level of the pulse from a delay line locked on the system clock.

### BRIEF DESCRIPTION OF THE DRAWINGS

FIGURE 1, comprised of Figures 1a, 1b and 1c, shows examples of continuous-time sigma delta (CTΣΔ) converters and discusses return-to-zero (RTZ) techniques.
FIGURE 2, comprised of Figures 2a, 2b and 2c, shows how RTZ pulses are generated from the regular system clock through a delay line to be jitter-free and shifted away from clock transitions.
FIGURE 3 depicts in more details how delay line is implemented.

### DETAILED DESCRIPTION

The following detailed description of the invention refers to the accompanying drawings. While the description includes exemplary embodiments, other embodiments are possible, and changes may be made to the embodiments described without departing from the spirit and scope of the invention.

The invention is illustrated through an example of a particular type of analog to digital converter referred to as continuous time (CT) sigma-delta converter often abbreviated as CTΣΔ. This type of ADC has gained popularity among designer communities because it is an inherently power-efficient architecture that eliminates the high-speed gain stages required for sampled-input ADCs, i.e., those that use a switched capacitor in input, and which are thus referred to as discrete-time (DT) converters. Because settling requirement of CT circuitry is intrinsically lower than the one of its DT counterpart a CTΣΔ has a smaller footprint and/or dissipate less power at a same level performance. Moreover, the CT input circuitry is also inherently alias-free. Indeed, because input is not sampled, designers have not to worry with aliasing that would result of a sampled input signal containing energy above the so-called Nyquist frequency band, i.e., above half the sampling frequency of the input signal. Hence, DT converters always also require an anti-aliasing low-pass filter in front of the input sampling stage. This contributes significantly to worsen area and power requirements of DT converters and, generally, of input sampled converters.

In spite of these key advantages over other types of converters the actual use of CTΣΔ's has long been delayed since it was first disclosed in 1962 (by H.Inose and al. in paper entitled "A telemetering system by code modulation, delta-sigma modulation," published in IRE Trans. on Space, Electronics and Telemetry, SET-8, pp. 204-209, Sept. 1962). Indeed, a specific problem of CTΣΔ's is due to the fact that this type of converter is however particularly sensitive to the overall quality of its clocking circuitry. At some extent, depending on particular designs and implementations, any clock jitter, noise and asymmetries of duty-cycle and of rise and fall times are susceptible to directly translate into the converter output to degrade the signal to noise ratio (SNR). Also, the linearity of the converter can be affected by clocking and driving signal flaws.

It is only after various techniques have been devised, since the 90's, to overcome this sensitivity to clocking that CTΣΔ's have seen their actual use growing significantly. The general approach to tackle the clocking problem consists in allowing a precise control of windows during which CTΣΔ converters are actually active so that they do no longer require any expensive high quality clocking system to operate properly. Thus, allowing the delivery of good SNR, close to the theoretical figures for the particular converter design considered, from any low-cost clocking system of the kind used for digital IC's so that mixed-signal integrated circuits can also use it for the analog part.

Called return-to-zero (RTZ) this kind of converters and, generally, any type of circuits used in the analog part of a mixed-signal integrated circuit that would be sensitive to clocking flaws is devised so that it can be turn into a non active or idle state during which it does nothing.

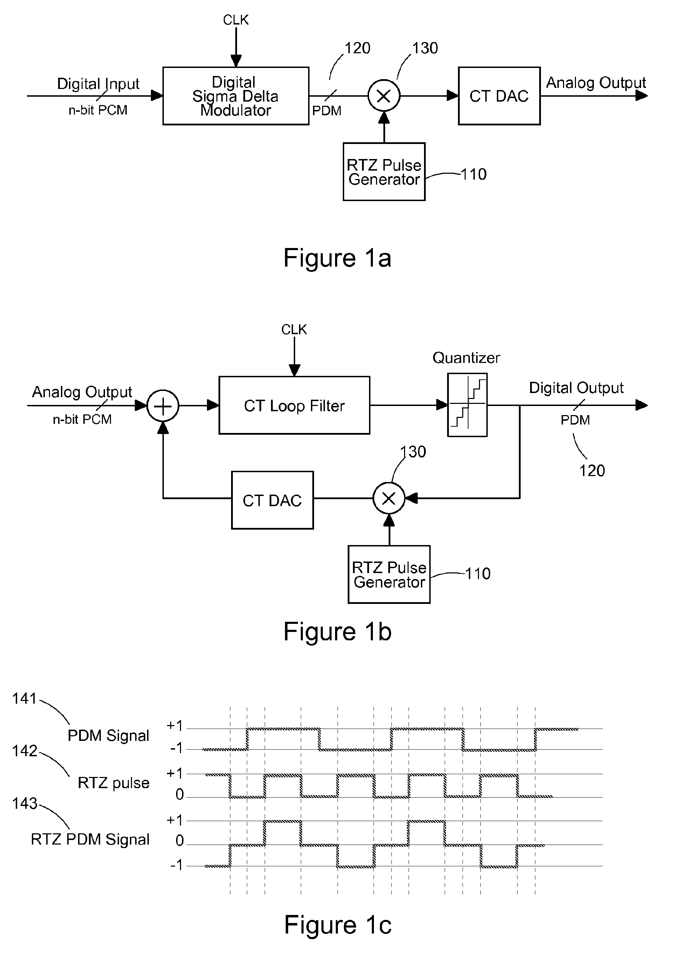

**Figure 1**, comprised of Figures 1a, 1b and 1c, shows examples of CTΣΔ converters on which the invention can best apply. The invention does not address any particular design type of return-to-zero CTΣΔ Numerous alternate implementations exist in digital and analog forms or using a mix of them. Figure 1a shows a typical example of a CTΣΔ digital-to-analog converter, and Figure 1b a CTΣΔ analog-to-digital converter that those skilled in this art can easily recognized. To be of the RTZ kind, converters must however include, in one way or another, a mode in which converters can be turn idle.

As a result of the over-sampling performed in any ΣΔ converters, a single-bit, and possibly multi-bit, pulse density modulation (PDM) signal is generated. The density of active levels of this PDM signal is indicative of the value of the analog signal being converted. The return-to-zero is achieved by inserting a means 130 to turn to an idle state this path. Hence, individual bits of the single-bit or multi-bit PDM signal 120, getting out of the quantizer or sigma-delta modulator, are multiplied or logically ANDed with an RTZ pulse signal delivered by the generator 110. As shown in Figure 1c, a single-bit PDM signal 141 that switches between -1 and +1 levels is multiplied by a pulse 142 having a portion (typically half) of the PDM level duration at one, and remaining time at zero. The resulting signal 143 is a ternary signal of values -1, 0 and +1. Thus, PDM signal is active only during the active phase (level one) of the RTZ pulse delivered by the generator. In the remaining portion of the clock cycle converter circuitry is idle. Although active and non active pulses of the RTZ signal are shown to be equal in duration this is not however mandatory.

Hence, RTZ CTΣΔ converters, examples of which are shown in Figure 1a and 1b, can use the regular clock of the mixed-signal IC's even though the quality would not be sufficient for the analog part because it is too noisy, is too much jittered and/or has a duty cycle and rise and fall times that do not match the specification required by converters to reach their optimal level of SNR. Instead, SNR becomes only dependent of the quality of the RTZ pulses that can be carefully tuned and controlled as explained in the following description.

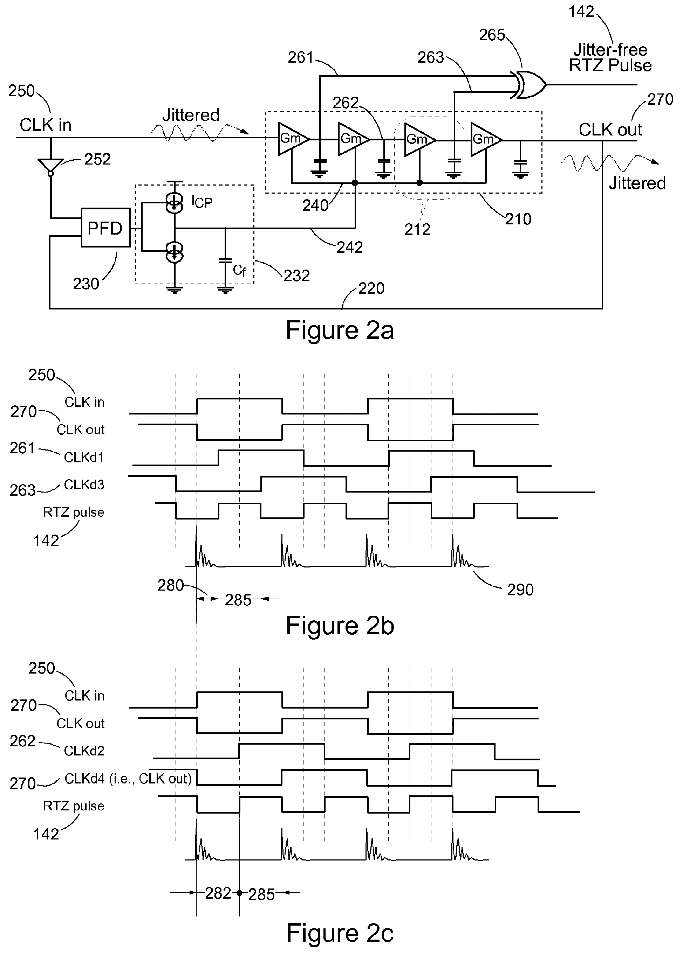

**Figure 2**, comprised of Figures 2a, 2b and 2c, shows how RTZ pulses are generated from the regular system clock to be jitter-free.

As explained in previous figure, PDM signals of RTZ converters are becoming active only while RTZ pulse 142 is turn on (at level +1). The core idea behind obtaining RTZ circuitry of converters jitter-free is to make this pulse entirely determined by controlled delay elements so that the active level becomes totally uncorrelated with the clock timing edges of the regular digital clock. Only, the average repetition rate is set by the input clock generally supplied from an accurate quartz oscillator.

This is achieved as shown in Figure 2a by using a delay line 210 made, in this example, of four individual identical delay elements like 212. The RTZ pulse timing width then becomes totally determined by the propagation time of the delay line. To prevent the delay line propagation time to be strongly dependent of process parameters, power supply variations and temperature, the delay line is inserted in a delay locked loop (DLL) 220 that continuously adjusts the propagation delay of delay elements to match the period of the input clock whose average value is accurately set by the quartz of the system clock.

The four individual delay elements of this exemplary implementation of the delay line are preferably made of transconductance cells noted Gm. Transconductance cells are standard electronic analog building blocks existing as off-the-shelf components under the form of operational transconductance amplifiers (OTA) and that can be integrated as well in any mixed-signal IC. They behave as a constant current source or current sink (depending of the polarity of the input voltage) thus delivering or drawing an adjustable constant current irrespective of the output voltage they need to apply to obtain this current. Transconductance is adjusted by the feedback loop 220 through the phase/frequency detector (PFD) 230 which sets the corresponding inputs of the four Gm cells 240 through a charge pump 232. In this exemplary implementation the total delay of the delay line is auto adjusted by DLL to match half a period of the system clock 250 since system clock is inverted 252 in front of PFD 230.

A charge pump system is a standard device constituted of a cascade of a gated current source and a gated current sink whose output drives a capacitor. Depending on the gate logic state (0/1), the current is either sourced to the capacitor creating an increasing voltage on the capacitor, our sinked on the capacitor creating a decreasing voltage.

PFD 230 is a standard analog device whose output depends on the phase/frequency difference between the two oscillating input signals, i.e., in this example, the inverted system clock used as a reference signal and the signal applied by the feedback loop 220. The output delivers a signal that is a function of the phase difference between the two PFD inputs. The output signal is amplified by the following charge pump 232 which acts as a direct current (DC to DC) converter.

In a Phase Lock Loop, the PFD compares phases of the reference clock to the VCO (Voltage Controlled Oscillator) generated clock. The difference in phase is translated into a voltage pulse whose width is proportional the phase difference. The sign of the pulse is also determined by the sign of PFD input phase difference. This pulse gates a charge pump circuit whose role is to charge a capacitor with a positive or negative current, depending on the sign of the pulse, for the duration of the pulse, creating thus an integrated voltage on the capacitor. This voltage is used to tune a VCO. In a closed loop, the VCO output clock accurately locks to the reference clock.

Then, to produce the jitter-free RTZ pulse 142 needed to drive a CTΣΔ converter, the first 261 and the third 263 delay element outputs are passed through a XOR gate 265. Hence, as shown in Figure 2b, the active pulse width 285 of the RTZ pulse is completely and solely determined by the propagation delay of the two middle delay elements of the delay line. The intermediate delayed signals, 261 and 263, that feed the XOR producing the jitter-free RTZ pulse 260, are delayed respectively of one fourth and three fourth of a half clock cycle so that the active part 285 of the RTZ pulse is safely kept away from the noise 290 produced by the digital part at each rising and falling transition of the digital system clock 250. As discussed in the background section, the main source of disturbances for the analog part in a mixed-signal IC is indeed the switching occurring in the digital circuitry which, through substrate coupling and propagation through the power supply lines (ground and power lines), would seriously disturb the analog circuitry if not accommodated as in the scheme of the invention. Thus the invention provides a temporal shift of the RTZ pulse in regard to the clock transitions.

Hence, insensitivity to clock jitter is obtained because the RTZ active pulse is entirely determined by the propagation delay of the two middle delay elements. Although jitter of the clock 250 may possibly leak to delay line through PFD block 230, output charge pump 232, and feedback line 242 used to tune the delay elements, charge pump acts as a very efficient filter to prevent clock jitter to propagate to the delay line through this path.

Also, insensitivity to power supply and substrate disturbances is obtained, as explained above, by keeping the active part of RTZ pulse 285 sufficiently away 280 from system clock transitions to let digital circuitry switch completely, reaching a steady state, before sensitive analog circuitry is becoming active; thus, ensuring a time orthogonality of the operations between digital and analog parts of a mixed-signal IC.

In an alternate implementation of the above scheme, the XOR inputs can be instead connected to the second 262 and fourth delay elements, i.e., the output clock 270. In which case, the timings are becoming those shown in Figure 2c leaving even more time 282 to digital circuitry to reach its steady state.

Those skilled in the art will recognize that further modifications can be brought to the above exemplary implementation while still achieving the objectives of the invention. Although four delay elements represent a good tradeoff between implementation complexity and fulfillment of these objectives a fewer or greater number of delay elements could be as well used to implement the delay line. Four delay elements allow a straightforward decoding of the pulse with a simple XOR. If fewer or more than four delays are used the decoding circuitry can be different of a simple XOR. More delays allow a greater flexibility in the adjustment of the shift at the expense of a slightly more complex decoding circuit. Also, DLL can be optionally locked on the full period of the system clock.

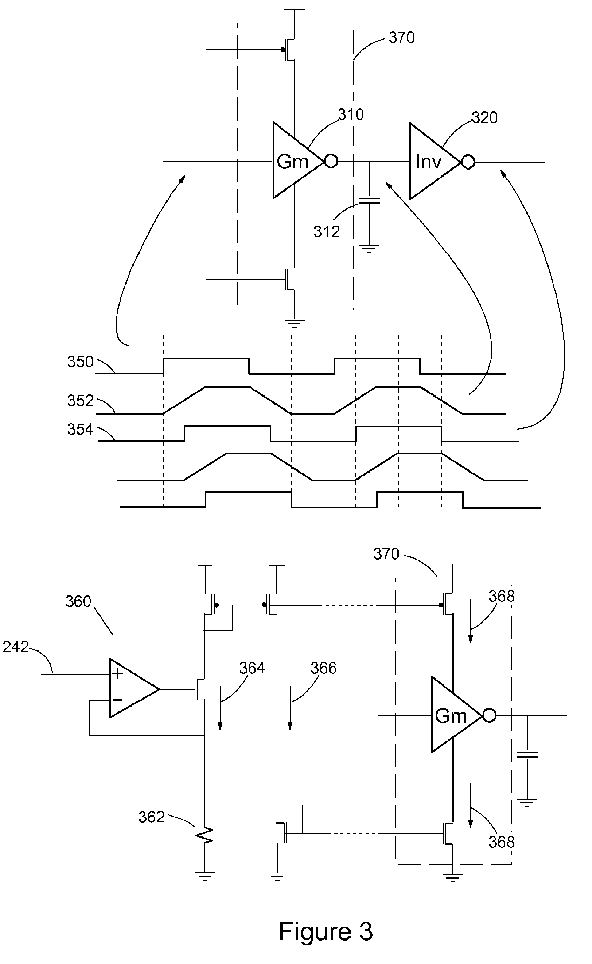

**Figure 3** depicts in more details how delay line is implemented.

As already discussed, the transconductance devices 310 of the delay line consist of adjustable positive and negative switch-able current sources/sinks loaded with a capacitor 312. Hence, an input square wave signal 350, e.g., the system clock applied on the first stage, linearly charges or discharges the capacitor within a voltage range limited by the power supply values. This produces a triangular wave signal as shown 352. Every transconductance device is followed by a logical inverter 320 (not shown in Figure 2), e.g., a CMOS (complementary metal oxide semiconductor) inverter since this technology, that has been devised to implement digital IC's, is now also used to implement mixed-signal IC's. The purpose of the inverter is to re-drive the triangular signal 352 in order to deliver again a squared signal 354 to the input of the next Gm cell. This repeats with each of the four cells used by the exemplary implementation of the delay line shown in Figure 2.

Through DLL, the current delivered by each Gm cell is automatically adjusted by the loop to compensate for the variations of process parameters, power supply value and operational temperature of the mixed-signal IC in which a pulse generator according to the invention is embedded. The adjustment is performed by the voltage 242, delivered by the charge pump circuit 232 shown in Figure 2, and which is linearly converted into current. The voltage to current conversion is implemented as shown 360 using an input differential pair that forces voltage 242 over resistor 362. The resulting current 364 is mirrored 366 and also used as a reference current for the driven Gm cells. The reference current of the upper 368 and lower 369 sections are used, respectively, to source or sink a corresponding constant current to/from the capacitive load 312 depending on the voltage value applied to the input of the transconductance device 310, e.g., by a preceding inverter 320.

In the exemplary implementation of Figure 2 and 3 each delay element is devised to achieve an optimal delay of one eight of the system clock, under nominal conditions of process, power supply and temperature, so that timings 280 can be easily met. The maximum and minimum achievable delays are estimated for the worst case values of these parameters.

As seen in the foregoing description of the invention, clocks of IC's are polluted with timing jitter which render very difficult, if not impossible, the realization of circuits able to perform conversion from analog to digital domains, or vice-versa, reaching a level of performance sufficient in terms of SNR, resolution and linearity to meet the requirements of demanding applications, e.g., high fidelity audio applications. This is particularly the case of continuous time sigma delta (CTΣΔ) converters which are known to be very sensitive to the quality of their clocking system. In an attempt to overcome this problem and others, the vast majority of continuous time (CT) converters are said to be return-to-zero (RTZ) converters. They carry out various schemes to control the portion of the clock cycle during which the converter is actually active. Outside of this window the converter is kept idle; thus, does nothing. The invention manages to generate a RTZ pulse, which sets the window during which the converter is active, and which is free of system clock jitter. The non active part of the pulse may contain jitter, but this has no detrimental effect on the converter since it is then idle. The invention thus discloses a circuit that generates a jitter-free pulse from the jittered system clock. To achieve this, the RTZ active pulse is completely, and solely, determined by propagation delays applying to the jittered system clock passed through delay elements of a delay line. Moreover, to make the delays insensitive to the environment and process parameters, the delay line is inserted in a delay locked loop (DLL) locked on the average period, or fraction of, of the system clock, which is assumed to have quartz accuracy.

Making the RTZ pulse free of clock jitter is however not sufficient to reach the high level of performances expected for demanding applications such as high-fidelity audio applications. An even more disturbing source of noise is found in mixed-signal integrated circuits (IC's) due to the close proximity of digital circuits that all possibly switch on system clock transitions. Through substrate and/or power supply distribution lines, a high level of noise is thus coupled to the highly sensitive analog nodes. Hence, the invention further discloses means to render RTZ CTΣΔ converters, and generally any sensitive analog circuitry, insensitive to this kind of noise by moving away from the system clock transitions, the window during which RTZ analog circuitry is made active.

## Claims

1. A pulse generator for driving return-to-zero circuitry, **characterized in that**:
it comprises:
means for generating a pulse from a system clock (250),
a delay line (210) driven by the system clock (250),
decoding means associated to the delay line for shifting away (280, 282) the active level of the pulse from transitions of the system clock(250),
it is arranged so that the delay line is locked on the system clock (250) and the active level (285) of the pulse is determined by the delay line.

2. The pulse generator according to claim 1 wherein the decoding means are arranged for decoding (265) a duration and a shift of the active level from outputs of individual delay elements (212) forming the controlled delay line.

3. The pulse generator according to the preceding claim comprising means for locking (220) the controlled delay line on the period, or fraction of, of the regular system clock.

4. The pulse generator according to the preceding claim comprising means for locking (252) the controlled delay line on half a period of the regular system clock.

5. The pulse generator according to the preceding claim wherein each individual delay element includes a transconductance device (310) and an inverter (320).

6. The pulse generator according to the preceding claim comprising means for adjusting a reference current (368) of the transconductance devices from a feedback voltage (242) generated from a phase frequency detector (230) and a charge pump (232) both part of the means for locking the controlled delay line.

7. The pulse generator according to the preceding claim wherein the delay line (210) is comprised of four individual delay elements.

8. The pulse generator according to the preceding claim arranged so that the active level of the pulse is shifted of one eight (280) of the system clock period from the regular system clock transitions.

9. The pulse generator according to the preceding claim arranged so that the active level of the pulse is shifted of one fourth (282) of the system clock period from the regular system clock transitions.

10. The pulse generator according to claim 2 wherein the means for decoding are an exclusive or gate (265).

11. The pulse generator of any according to the the preceding claims arranged so that the effect of noise coupling is minimized by time shifting the said noise coupling into a non-active time window of the return-to-zero circuitry.

12. A return-to-zero analog to digital, or digital to analog, converter including a pulse generator (110) according to any one of preceding claims.

13. The converter according to the preceding claim wherein the converter is of a continuous-time sigma-delta type.

14. An audio-phonics apparatus comprising a converter according to any one of the two preceding claims.

15. A method for generating a pulse aimed at driving return-to-zero circuitry, **characterized in that** it comprises the steps of:
generating a pulse from a system clock (250),
shifting away (280, 282) the active level of the pulse from transitions of the system clock through a delay line,
decoding (265) a duration and a shift of the active level from outputs of individual delay elements (212) forming the controlled delay line;
locking (220) the controlled delay line on the period, or fraction of, of the regular system clock
determining an active level (285) of the pulse from a delay line (210) locked on the system clock (250).
